# EUROPEAN PATENT APPLICATION

(11) **EP 4 550 956 A1**
(43) Date of publication of application: **07.05.2025**
(21) Application number: 24203405.6
(22) Date of filing: 27.09.2024
(51) Int. Cl.: H05K 7/20

(54) **MOTOR CONTROL UNIT, POWERTRAIN, AND VEHICLE**

(30) Priority: 30.10.2023 CN 202311434470
(71) Applicant: Huawei Digital Power Technologies Co., Ltd., Shenzhen, Guangdong 518043 (CN)
(72) Inventor: YU, Kang, Shenzhen, 518043 (CN); ZHANG, Weilong, Shenzhen, 518043 (CN); XU, Ziyou, Shenzhen, 518043 (CN); XU, Yankun, Shenzhen, 518043 (CN); GAO, Jiasheng, Shenzhen, 518043 (CN); FAN, Chao, Shenzhen, 518043 (CN)
(74) Representative: Gill Jennings & Every LLP

(57) **Abstract**

This application relates to the field of motor control unit technologies, and in particular, to a motor control unit, a powertrain, and a vehicle. The motor control unit includes a three-phase bridge arm, a capacitor module, and a heat dissipation panel group. The capacitor module includes a capacitor housing and a capacitor core package, and the capacitor housing includes a first sub-housing and a second sub-housing. A gap between the first sub-housing and the second sub-housing forms an accommodating cavity in a first direction, and the accommodating cavity is used to accommodate the capacitor core package. The three-phase bridge arm includes a plurality of power modules. The heat dissipation panel group is configured to dissipate heat for the plurality of power modules, the heat dissipation panel group is configured to be fixedly connected to a side that is of the first sub-housing and that is away from the capacitor core package in the first direction, and a gap between the heat dissipation panel group and the first sub-housing in the first direction is used to form a coolant flow channel. The first sub-housing includes two flow channel openings, and the two flow channel openings are used to communicate with the coolant flow channel. The coolant flow channel in the motor control unit exchanges heat with the capacitor core package via a first sub-housing, so that heat exchange efficiency of the capacitor core package can be improved.

## Description

### TECHNICAL FIELD

This application relates to the field of motor control unit technologies, and in particular, to a motor control unit, a powertrain, and a vehicle.

### BACKGROUND

Currently, electric vehicles represented by pure electric vehicles and hybrid electric vehicles are increasingly popular among consumers, and internal space and comfort of the electric vehicle are also increasing. A motor control unit in the electric vehicle is configured to convert a direct current provided by a power battery into an alternating current to supply power to a drive motor, to drive wheels of the electric vehicle via the drive motor.

However, the motor control unit includes a plurality of components such as a liquid cooling radiator, a capacitor module, and a circuit board. The liquid cooling radiator can dissipate heat for a capacitor core package in the capacitor module. However, heat generated by the capacitor core package needs to be transferred to the liquid cooling radiator via a plurality of housings. As a result, heat dissipation effect on the capacitor core package is poor.

### SUMMARY

Embodiments of this application provide a motor control unit. A coolant flow channel in the motor control unit exchanges heat with a capacitor core package via a first sub-housing, so that heat exchange efficiency of the capacitor core package can be improved.

According to a first aspect, this application provides a motor control unit. The motor control unit includes a three-phase bridge arm, a capacitor module, and a heat dissipation panel group. The capacitor module includes a capacitor housing and a capacitor core package, and the capacitor housing includes a first sub-housing and a second sub-housing. The first sub-housing and the second sub-housing are spaced in a first direction, a gap between the first sub-housing and the second sub-housing forms an accommodating cavity in the first direction, and the accommodating cavity is used to accommodate the capacitor core package. The three-phase bridge arm includes a plurality of power modules. The heat dissipation panel group is configured to dissipate heat for the plurality of power modules, the heat dissipation panel group is configured to be fixedly connected to a side that is of the first sub-housing and that is away from the capacitor core package in the first direction, and a gap between the heat dissipation panel group and the first sub-housing in the first direction is used to form a coolant flow channel. The first sub-housing includes two flow channel openings, and the two flow channel openings are used to communicate with the coolant flow channel. In this embodiment, a refrigerant directly enters the coolant flow channel through the coolant flow channel, the coolant channel can dissipate heat for the capacitor core package located in the accommodating cavity, and there is a first sub-housing between the coolant channel and the accommodating cavity. This can also improve heat dissipation performance of the coolant channel for the capacitor core package, and improve heat dissipation efficiency of the capacitor core package.

In an embodiment, a side that is of the heat dissipation panel group and that is away from the first sub-housing is used to fasten the plurality of power modules, and the plurality of power modules are spaced in a second direction. The plurality of power modules are spaced in the second direction, so that a size of the motor control unit in the first direction can be reduced.

The accommodating cavity includes an opening, an orientation of the opening is in a third direction, so that the capacitor core package is embedded into the accommodating cavity along the opening. This reduces assembly difficulty of the capacitor module.

In an embodiment, the heat dissipation panel group includes a cavity and at least one group of through holes, each group of through holes includes a liquid inlet through hole and a liquid outlet through hole, each liquid inlet through hole is configured to communicate the coolant flow channel with the cavity, and each liquid outlet through hole is configured to communicate the coolant flow channel. The cavity is in communication with the coolant channel through the liquid inlet through hole and the liquid outlet through hole. This facilitates circulation of the refrigerant in the heat dissipation panel group, and can also improve heat dissipation effect on the power module.

In an embodiment, the heat dissipation panel group includes a mainboard and at least one cover plate, the mainboard is configured to be fixedly connected to the side that is of the first sub-housing and that is away from the capacitor core package in the first direction, the at least one cover plate is configured to be fixedly connected to a side that is of the mainboard and that is away from the first sub-housing in the first direction, a gap between the mainboard and the at least one cover plate is used to form the cavity, and a side that is of the at least one cover plate and that is away from the mainboard in the first direction is used to fasten the plurality of power modules. The coolant flow channel can be formed in a gap between the mainboard and the first sub-housing, the cavity is formed between the mainboard and the at least one cover plate, and the coolant flow channel is connected to the cavity, so that circulation efficiency of the refrigerant can be improved, and the heat dissipation effect on the power module can be improved.

In an embodiment, the heat dissipation panel group includes a plurality of cavities, a gap between each cover plate and the mainboard is used to form a cavity, the plurality of cavities are spaced in the second direction, and each group of through holes is configured to communicate the coolant flow channel with a cavity. In this manner, the heat dissipation panel group includes a plurality of cover plates, a cavity is formed between each cover plate and the mainboard, and each cavity may correspond to a power module, so that the heat dissipation effect on the power module can be improved.

In an embodiment, a side that is of the mainboard and that is away from the first sub-housing includes a plurality of first grooves, and each first groove is configured to be fixedly connected to the cover plate to form the cavity, where each group of through holes penetrates a groove bottom of the first groove in the first direction, and the plurality of first grooves are sequentially spaced in the second direction. In this manner, a size of the heat dissipation panel group in the first direction can be reduced.

In an embodiment, the heat dissipation panel group includes a plurality of ring-shaped plate frames, each ring-shaped plate frame is configured to fixedly connect the cover plate to the first groove, and a material of the ring-shaped plate frame is different from a material of either the cover plate or the groove. The ring-shaped plate frame can improve convenience of connecting the cover plate to the first groove.

In an embodiment, a side that is of the mainboard and that faces the first sub-housing includes a plurality of second grooves, where each group of through holes penetrates a groove bottom of the second groove in the first direction, and the plurality of second grooves are spaced in the second direction. The plurality of second grooves are disposed, so that a capacity of the coolant flow channel can be improved.

In an embodiment, the side that is of the mainboard and that faces the first sub-housing includes a plurality of groove separators, each groove separator is configured to separate one second groove into two second sub-grooves, and the two second sub-grooves are configured to communicate with a group of through holes separately. The groove separator is disposed, so that the second groove can be separated, to ensure that when the refrigerant passes through the second groove, incoming liquid and outgoing liquid are not mixed, thereby improving a heat exchange capability of the cavity.

In an embodiment, a side that is of the first sub-housing and that faces the heat dissipation panel group includes a third groove, and a gap between the third groove and the heat dissipation panel group in the first direction forms the coolant flow channel. The coolant flow channel is formed by the third groove on the first sub-housing and the heat dissipation panel group, and the first sub-housing between the coolant flow channel and the capacitor core package has a smaller thickness in the first direction. This helps improve a heat dissipation capability of the coolant flow channel for the capacitor core package.

In an embodiment, the side that is of the first sub-housing and that faces the heat dissipation panel group includes a housing separator, the housing separator is configured to separate the third groove into two third sub-grooves, one third sub-groove is configured to communicate with a liquid inlet through hole in at least one group of through holes, and the other third sub-groove is configured to communicate with a liquid outlet through hole in the at least one group of through holes. The housing separator separates the third groove into the two third sub-grooves, and the two third sub-grooves may be understood as a liquid inlet flow channel and a liquid outlet flow channel, to ensure that after the refrigerant enters the third groove, a refrigerant obtained after heat exchange is not mixed with a newly entering refrigerant, thereby improving heat dissipation effect of the coolant flow channel on the capacitor core package.

According to a second aspect, an embodiment of this application provides a powertrain. The powertrain includes a motor and the motor control unit according to any technical solution of the first aspect, and the motor control unit is electrically connected to the motor. The motor control unit is configured to: convert a direct current provided by a power supply into an alternating current, and output the alternating current to the motor.

According to a third aspect, an embodiment of this application provides a vehicle. The vehicle includes wheels and the powertrain according to the technical solution of the second aspect. The powertrain is configured to: receive power supplied by a battery and drive the wheels, to drive the vehicle to travel.

### BRIEF DESCRIPTION OF DRAWINGS

FIG. 1 is a diagram of a structure of a vehicle according to an embodiment of this application;
FIG. 2 is a diagram of an application scenario of a powertrain according to an embodiment of this application;
FIG. 3 is an exploded view of a motor control unit according to an embodiment of this application;
FIG. 4 is another exploded view of a motor control unit according to an embodiment of this application;
FIG. 5 is still another exploded view of a motor control unit according to an embodiment of this application;
FIG. 6 is yet another exploded view of a motor control unit according to an embodiment of this application;
FIG. 7 is a bottom view of a heat dissipation panel group of a motor control unit according to an embodiment of this application;
FIG. 8 is another bottom view of a heat dissipation panel group of a motor control unit according to an embodiment of this application;
FIG. 9 is a diagram of the structure in FIG. 8;
FIG. 10 is a diagram of a structure of a radiator of a motor control unit according to an embodiment of this application;
FIG. 11 is an exploded view of FIG. 10;
FIG. 12 is an exploded view of a radiator of a motor control unit according to an embodiment of this application;
FIG. 13 is another exploded view of a radiator of a motor control unit according to an embodiment of this application;
FIG. 14 is a diagram of a structure of a capacitor housing of a motor control unit according to an embodiment of this application;
FIG. 15 is a diagram of a structure of a capacitor module and a filter module of a motor control unit according to an embodiment of this application; and
FIG. 16 is a bottom view of a capacitor module of a motor control unit according to an embodiment of this application.

### Reference numerals:

1: vehicle; 10: vehicle body; 11: wheel; 12: vehicle-mounted load; 13: external power supply; 2: powertrain; 20: power supply module; 21: power battery; 22: motor; 3: motor control unit; 30: capacitor module; 300: capacitor housing; 3000: first sub-housing; 30000: flow channel opening; 30001: coolant flow channel; 30001a: third groove; 30001b: groove bottom; 30001c: groove wall; 30002: housing separator; 30003: liquid outlet flow channel; 30004: liquid inlet flow channel; 3001: second sub-housing; 3001a: fourth groove; 3003: accommodating cavity; 3004: lightening hole; 3005: support pillar; 301: capacitor core package; 302: direct current output copper bar; 31: three-phase bridge arm; 310: power module; 32: circuit board; 33: Hall magnetic core component; 330: Hall magnetic core; 331: copper bar connecting piece; 34: filter module; 340: filter; 341: direct current connecting piece; 35: heat dissipation panel group; 350: cavity; 351: mainboard; 351a: liquid inlet through hole; 351b: liquid outlet through hole; 351c: second groove; 351d: second sub-groove; 3510: first groove; 352: ring-shaped plate frame; 353: cover plate; 3530: heat dissipation fin; and 354: groove separator.

### DESCRIPTION OF EMBODIMENTS

A motor control unit in an electric vehicle is configured to convert a direct current provided by a power battery into an alternating current to supply power to a drive motor, to drive wheels of the electric vehicle via the drive motor. In the conventional technology, a liquid cooling radiator is stacked on a capacitor housing, and the capacitor housing is configured to accommodate a capacitor core package. Heat generated by the capacitor core package is transferred via the capacitor housing and a housing of the liquid cooling radiator, and the heat generated by the capacitor core package needs to pass through at least two housings for being conducted. As a result, heat dissipation effect on the capacitor core package is limited, and a service life of the capacitor core package is affected. In addition, the capacitor housing and the liquid cooling radiator are independent components. This causes the motor control unit to have a large quantity of components, an assembly process of the motor control unit to be complex, and the motor control unit to have a large volume.

In view of this, embodiments of this application provide a motor control unit, to resolve the foregoing problem. To make objectives, technical solutions, and advantages of this application clearer, the following further describes this application in detail with reference to accompanying drawings.

Terms used in the following embodiments are merely intended to describe specific embodiments, but are not intended to limit this application. Terms "one", "a", "the", "the foregoing", "this" and "the one" of singular forms used in this specification and the appended claims of this application are also intended to include expressions such as "one or more", unless otherwise specified in the context clearly.

Referring to "an embodiment", "some embodiments", or the like in the specification of this application indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

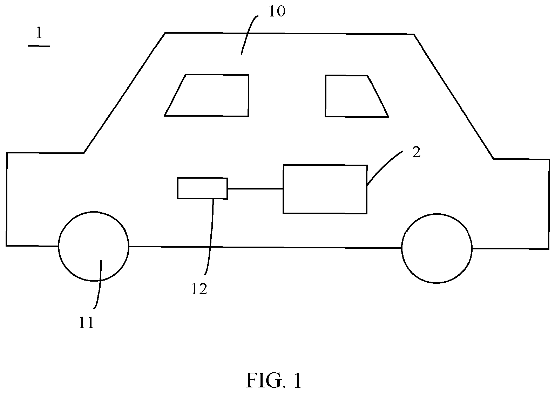

FIG. 1 is a diagram of a vehicle according to this application. Refer to FIG. 1. A vehicle 1 includes a vehicle body 10, wheels 11, a power battery 21, and a powertrain 2. The powertrain 2 is mounted on the vehicle body 10, and the power battery 21 supplies power to the powertrain 2. The powertrain 2 is configured to drive the wheels 11 of the vehicle 1. In an embodiment, the vehicle 1 includes the wheels 11 and the powertrain 2. The powertrain 2 is configured to drive the wheels 11 of the vehicle 1.

In this application, the vehicle 1 includes an electric vehicle (Electric Vehicle, EV), a battery electric vehicle (Battery Electric Vehicle, BEV), a hybrid electric vehicle (Hybrid Electric Vehicle, HEV), a range extended electric vehicle (Range Extended Electric Vehicle, REEV), a plug-in hybrid electric vehicle (Plug-in Hybrid Electric Vehicle, PHEV), or a new energy vehicle (New Energy Vehicle).

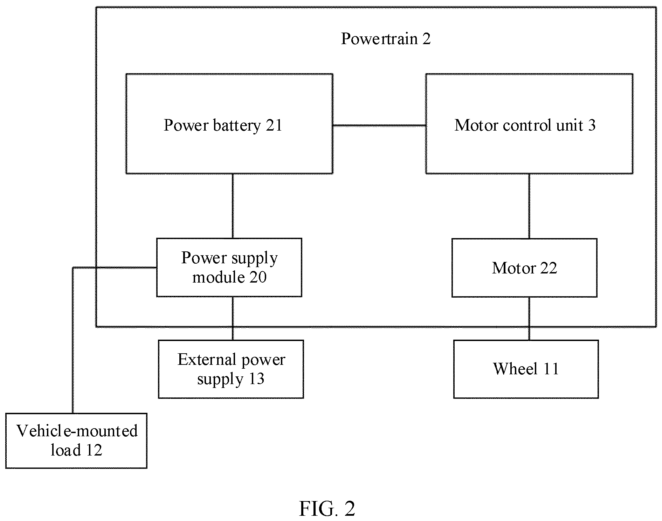

FIG. 2 is a diagram of a vehicle and a powertrain according to an embodiment of this application. As shown in FIG. 2, a vehicle 1 includes a vehicle body 10, wheels 11, a power battery 21, a power supply module 20, a vehicle-mounted load 12, and a powertrain 2.

In an embodiment, the powertrain 2 includes a motor control unit 3 and a motor 22. Refer to FIG. 2. The power battery 21 supplies power to the motor 22 via the motor control unit 3. The motor control unit 3 is configured to convert a direct current provided by the power battery 21 into an alternating current. The motor 22 receives the alternating current and converts the alternating current into kinetic energy to drive the wheels 11.

In an embodiment, the power supply module 20 is configured to: receive power supplied by an external power supply 13, and charge the power battery 21. In an embodiment, the power supply module 20 is configured to supply power to the vehicle-mounted load 12.

In this application, the external power supply 13 may be an alternating current power grid, an alternating current charging pile, or a direct current charging pile. The power supply module 20 may be a power distribution unit or an on-board charger. The vehicle-mounted load 12 includes at least one of a compressor, a battery heating module, a seat heating module, and a direct current low voltage power supply.

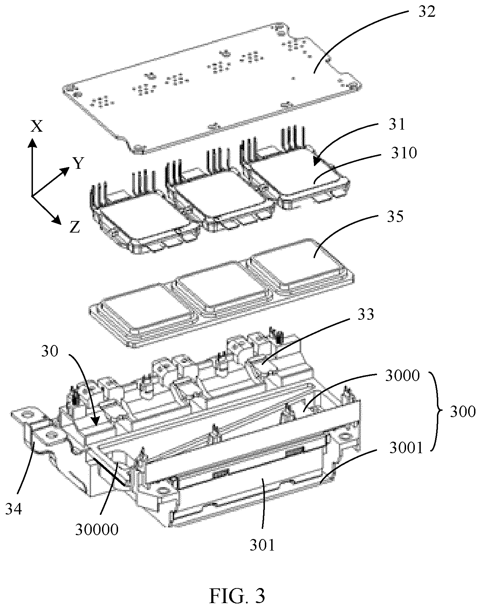

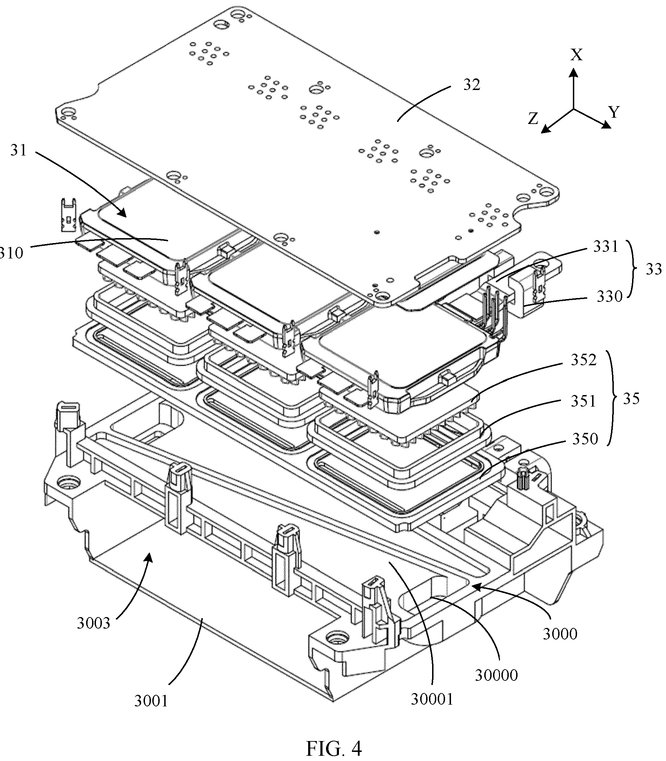

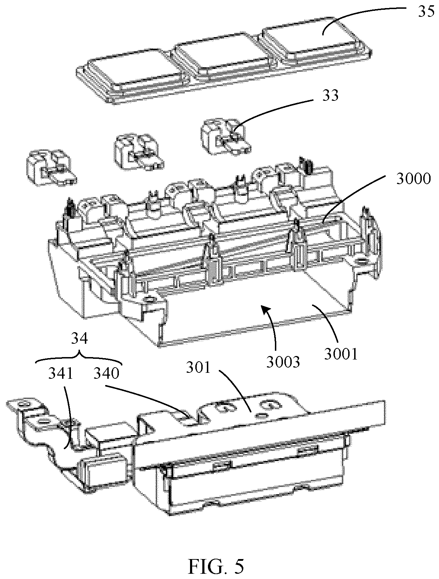

FIG. 3 is an exploded view of a motor control unit according to an embodiment of this application. FIG. 4 is another exploded view of the motor control unit according to an embodiment of this application. FIG. 5 is still another exploded view of the motor control unit according to an embodiment of this application. Refer to FIG. 3, FIG. 4, and FIG. 5. The motor control unit includes a capacitor module 30, a heat dissipation panel group 35, a three-phase bridge arm 31, a circuit board 32, and a filter module 34.

In an embodiment, the capacitor module 30, the heat dissipation panel group 35, the three-phase bridge arm 31, and the circuit board 32 are stacked in a first direction X. In an embodiment, the capacitor module 30, the three-phase bridge arm 31, the heat dissipation panel group 35, and the circuit board 32 are stacked in the first direction X, and in the first direction X, the filter module 34 is mounted on a side that is of the capacitor module 30 and that is away from the three-phase bridge arm 31.

In an embodiment, the capacitor module 30 includes a capacitor housing 300 and a capacitor core package 301, and the capacitor housing 300 is configured to accommodate the capacitor core package 301.

In an embodiment, two ends of a bridge arm of each phase of bridge arm circuit in the three-phase bridge arm 31 are configured to electrically connect to the capacitor core package 301, and a midpoint of the bridge arm of each phase of bridge arm circuit is configured to output an alternating current to drive a motor. The three-phase bridge arm 31 includes a plurality of power modules 310, the plurality of power modules 310 are spaced in a second direction Y, and the heat dissipation panel group 35 dissipates heat for the plurality of power modules 310. Each power module 310 includes at least one power transistor, and the power transistor is configured to electrically connect to the capacitor core package 301.

In an embodiment, the filter module 34 includes a filter 340 and a direct current connecting piece 341. The filter 340 is configured to electrically connect to the capacitor core package 301 in the capacitor module 30. The direct current connecting piece 341 is configured to receive a direct current output by the power battery 21. The filter 340 is configured to receive the direct current of the direct current connecting piece 341.

In this application, the direct current output by the power battery 21 is transmitted to the filter 340 and the capacitor core package 301 via the direct current connecting piece 341, and the filter 340 and the capacitor core package 301 are configured to reduce a harmonic in the direct current. The circuit board 32 and the three-phase bridge arm 31 are configured to: receive the direct current and output an alternating current to drive a motor 22. The circuit board 32 is configured to control running of the power transistor in the power module 310. The circuit board 32 controls a parameter of an alternating current output by an inverter circuit.

In an embodiment, the capacitor housing 300 includes a first sub-housing 3000 and a second sub-housing 3001. The first sub-housing 3000 and the second sub-housing 3001 are spaced in the first direction X, and there is a gap between the first sub-housing 3000 and the second sub-housing 3001. The gap, the first sub-housing 3000, and the second sub-housing 3001 form an accommodating cavity 3003. An opening of the accommodating cavity 3003 is in a third direction Z, and the capacitor core package 301 is mounted in the accommodating cavity 3003. In this embodiment of this application, the opening of the accommodating cavity 3003 is in the third direction Y, and in a process in which the capacitor core package 301 is mounted in the accommodating cavity 3003 along the opening, the capacitor core package 301 does not interfere with the first sub-housing 3000 and the second sub-housing 3001. This improves convenience of assembling the motor control unit.

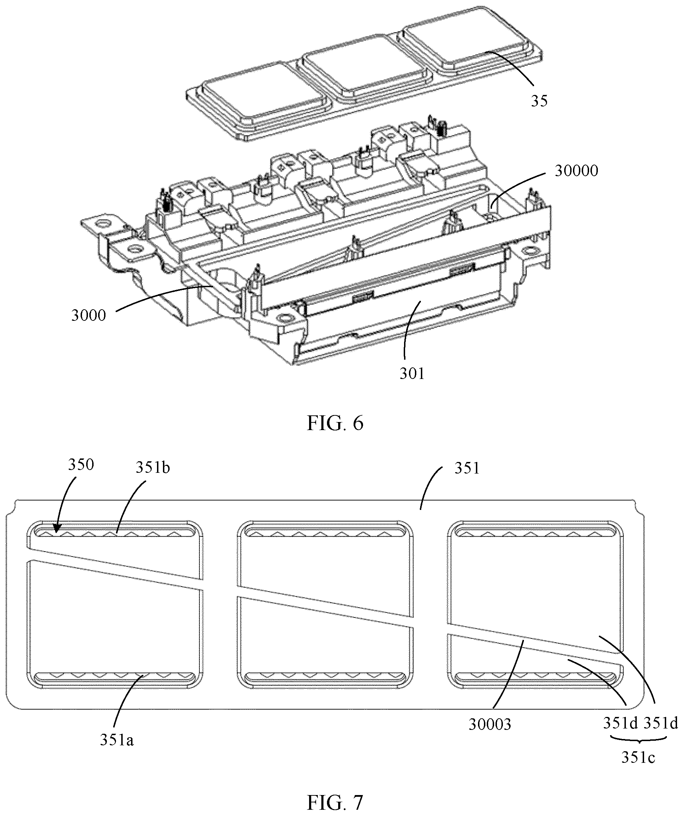

FIG. 6 is yet another exploded view of the motor control unit according to an embodiment of this application. Refer to FIG. 3 to FIG. 6. In an embodiment, the first sub-housing 3000 includes two flow channel openings 30000, and the two flow channel openings 30000 face the second sub-housing 3001 in the first direction X. The two flow channel openings 30000 are spaced in the second direction Y In this embodiment of this application, in the first direction X, the heat dissipation panel group 35 is fixedly connected to a side that is of the first sub-housing 3000 and that is away from the capacitor core package 301. There is a gap between the heat dissipation panel group 35 and the first sub-housing 3000 in the first direction X, and the gap forms a coolant flow channel 30001. The coolant flow channel 30001 is connected to the two flow channel openings 30000. In this manner, heat generated by the capacitor core package 301 can be directly transferred to the coolant flow channel 30001 via the first sub-housing 3000, and a refrigerant of the coolant flow channel 30001 absorbs, via the first sub-housing 3000, the heat generated by the capacitor core package. Compared with the conventional technology in which the heat generated by the capacitor core package 301 can be absorbed by the refrigerant only after passing through a plurality of housings, in this manner, the heat generated by the capacitor core package 301 is directly absorbed by the refrigerant via the first sub-housing 3000, so that heat dissipation efficiency of the capacitor core package 301 can be improved. For example, all of projection of the capacitor core package 301 in the first direction X is located in projection of the coolant flow channel 30001, and the heat generated by the capacitor core package 301 can be absorbed by the refrigerant in the coolant flow channel 30001 more quickly.

In an embodiment, projection of the two flow channel openings 30000 does not overlap the projection of the capacitor core package 301 in the first direction X. Pipelines through which the refrigerant enters the two flow channel openings 30000 do not need to avoid the capacitor core package 301. This improves mounting convenience. In addition, the two flow channel openings 30000 both face the second sub-housing 3001, so that the pipelines through which the refrigerant enters can also be located on a same side of the first sub-housing 3000, so that a structure of the motor control unit is more compact.

A distance between the two flow channel openings 30000 in the second direction Y is greater than a length of the accommodating cavity 3003. The capacitor core package 301 is located between the two flow channel openings 30000. In a process in which the refrigerant enters the two flow channel openings 30000 through the pipelines, the refrigerant can dissipate heat and cool the capacitor core package 301. A heat dissipation capability for the capacitor core package 301 is improved.

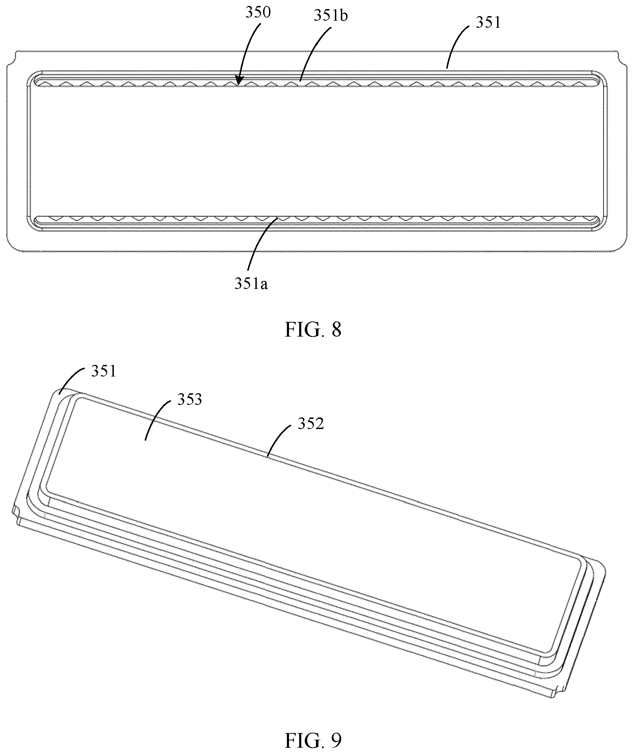

FIG. 7 is a bottom view of the heat dissipation panel group of the motor control unit according to an embodiment of this application. FIG. 8 is another bottom view of the heat dissipation panel group of the motor control unit according to an embodiment of this application. Refer to FIG. 4, FIG. 7, and FIG. 8. The heat dissipation panel group 35 includes at least one cavity 350 and at least one group of through holes, and each group of through holes includes a liquid inlet through hole 351a and a liquid outlet through hole 351b. Each liquid inlet through hole 351a is configured to communicate the coolant flow channel 30001 with the cavity 350, and each liquid outlet through hole 351b is configured to communicate the coolant flow channel 30001 and the cavity 350. After entering the coolant flow channel 30001 through one flow channel opening 30000, the refrigerant enters the cavity 350 through the liquid inlet through hole 351a. The refrigerant in the cavity 350 absorbs heat generated by the power module 310, after absorbing the heat, the refrigerant flows back to the coolant flow channel 30001 through the liquid outlet through hole 351b, and flows out through the other flow channel opening 30000, to complete heat dissipation for the power module 310. In this process, when flowing through the coolant flow channel 30001, the refrigerant can also dissipate heat for the capacitor core package.

FIG. 9 is a diagram of the structure in FIG. 8. Refer to FIG. 4, FIG. 8, and FIG. 9. In an embodiment, the heat dissipation panel group includes a mainboard 351 and a cover plate 353. In the first direction X, the mainboard 351 is fixedly connected to the side that is of the first sub-housing 3000 and that is away from the capacitor core package, and in the first direction X, a cover plate 353 is fixedly connected to a side that is of the mainboard 351 and that is away from the first sub-housing 3000. There is a gap between the mainboard 351 and a cover plate 353 in the first direction X, and the gap is used to form a cavity 350. At least one group of through holes are arranged on the mainboard 351, and in the first direction X, a liquid inlet through hole 351a and a liquid outlet through hole 351b that are included in a group of through holes penetrate the mainboard, to communicate the cavity 350 with the coolant flow channel 30001. When there is one cover plate 353, there are one or more groups of through holes.

In an embodiment, in the first direction X, the side that is of the mainboard 351 and that is away from the first sub-housing 3000 includes a first groove, and the first groove is configured to be fixedly connected to the cover plate 353 to form the cavity 350. At least one group of through holes is arranged at a groove bottom of the first groove, and each group of through holes penetrates the groove bottom of the first groove in the first direction X. In an embodiment, the heat dissipation panel group includes a plate frame, and the plate frame is a ring-shaped plate frame 352. The ring-shaped plate frame 352 is located between a cover plate 353 and a first groove in the first direction X, and the ring-shaped plate frame 352 is configured to fixedly connect the cover plate 353 to the first groove. It may be understood as that the ring-shaped plate frame 352 connects the mainboard 351 to the cover plate 353, the ring-shaped plate frame 352, the mainboard 351, and the cover plate 353 form the cavity 350, and the refrigerant communicates the cavity 350 with the coolant flow channel 30001 through the liquid inlet through hole 351a and the liquid outlet through hole 351b that are arranged on the mainboard 351. A material of the cover plate 353 is copper or an aluminum alloy, a material of the ring-shaped plate frame 352 is high-temperature-resistant glycol coolant plastic, and the cover plate 353 and the ring-shaped plate frame 352 are fastened by using a nano injection molding process. The mainboard 351 and the ring-shaped plate frame 352 are made of a same material, and the mainboard 351 and the ring-shaped plate frame 352 are sealed and fastened through laser welding or by using a sealant. It may be understood as that the material of the ring-shaped plate frame 352 is different from a material of either the cover plate 353 or the first groove.

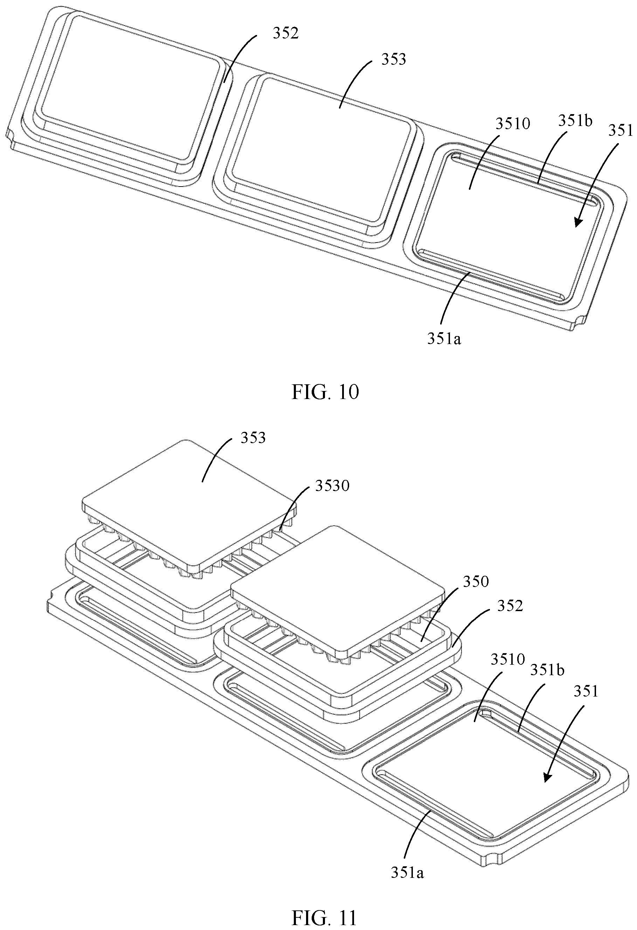

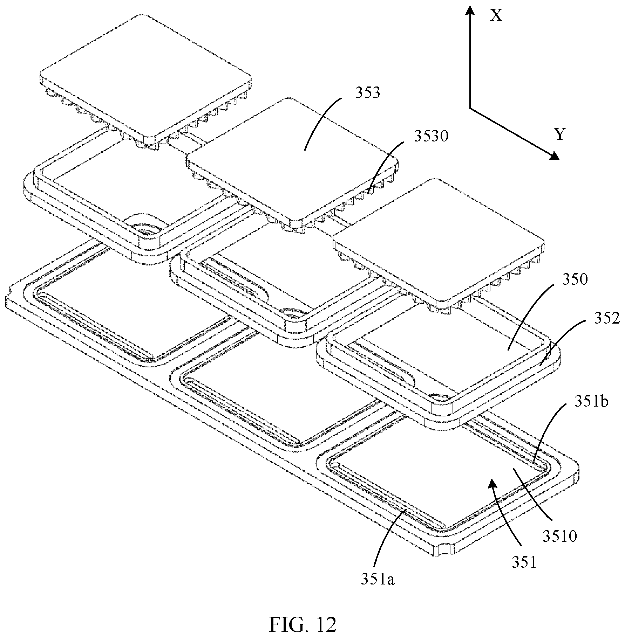

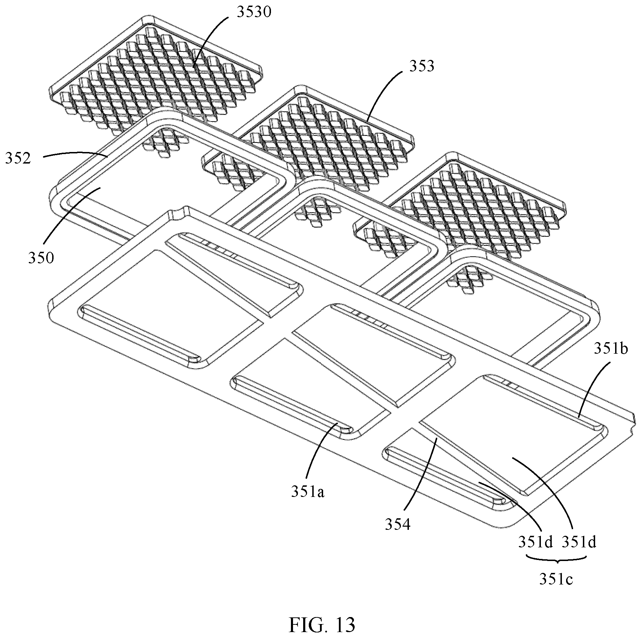

FIG. 10 is a diagram of a structure of a radiator of the motor control unit according to an embodiment of this application. FIG. 11 is an exploded view of FIG. 10. FIG. 12 is an exploded view of the radiator of the motor control unit according to an embodiment of this application. FIG. 13 is another exploded view of the radiator of the motor control unit according to an embodiment of this application. Refer to FIG. 4 and FIG. 10 to FIG. 13. In an embodiment, the heat dissipation panel group 35 includes the mainboard 351 and a plurality of cover plates 353. In the first direction X, the mainboard 351 is fixedly connected to the side that is of the first sub-housing 3000 and that is away from the capacitor core package. In the first direction X, the plurality of cover plates 353 are fixedly connected to the side that is of the mainboard 351 and that is away from the first sub-housing 3000. A gap between each cover plate 353 and the mainboard 351 forms a cavity 350 in the first direction X, and gaps between the plurality of cover plates 353 and the mainboard 351 form a plurality of cavities 350. The plurality of cavities 350 are spaced in the second direction Y, and each group of through holes is configured to connect a cavity 350 and the coolant flow channel 30001.

In an embodiment, in the first direction X, the side that is of the mainboard 351 and that is away from the first sub-housing 3000 includes a plurality of first grooves 3510, and the plurality of first grooves 3510 are spaced in the second direction Y Each first groove 3510 is configured to fasten a cover plate 353, and each first groove 3510, a cover plate 353, and the side that is of the mainboard 351 and that is away from the first sub-housing 3000 are enclosed to form a cavity 350. Each group of through holes penetrates a groove bottom of one first groove 3510 in the first direction X, to communicate the cavity 350 with the coolant flow channel. That each group of through holes penetrates the groove bottom of the first groove in the first direction X may be understood as that each group of through holes penetrates the mainboard 351 in the first direction X.

In an embodiment, the heat dissipation panel group 35 includes a plurality of plate frames, and the plate frame is the ring-shaped plate frame 352. The plurality of ring-shaped plate frames 352 are located between the plurality of cover plates 353 and the plurality of first grooves 3510 in the first direction X, and the ring-shaped plate frame 352 is configured to fixedly connect a cover plate 353 to a first groove 3510. In this case, the plurality of ring-shaped plate frames 352, the mainboard 351, and the plurality of cover plates 353 form a plurality of cavities, and the refrigerant communicates the cavity 350 with the coolant flow channel 30001 through the liquid inlet through hole 351a and the liquid outlet through hole that penetrate the mainboard 351. The material of the cover plate 353 is the copper or the aluminum alloy, the material of the ring-shaped plate frame 352 is the high-temperature-resistant glycol coolant plastic, and the cover plate 353 and the ring-shaped plate frame 352 are fastened by using the nano injection molding process. The mainboard 351 and the ring-shaped plate frame 352 are made of the same material, and the mainboard 351 and the ring-shaped plate frame 352 are sealed and fastened through the laser welding or by using the sealant. It may be understood as that the material of the ring-shaped plate frame 352 is different from a material of either the cover plate 353 or the first groove 3510.

In the foregoing embodiment, sealing rings are disposed between the mainboard 351 and the first sub-housing 3000 and between the mainboard 351 and the ring-shaped plate frame 352, to improve sealing between the mainboard 351 and the first sub-housing 3000 and between the mainboard 351 and the ring-shaped plate frame 352, thereby reducing a risk of refrigerant leakage. In this embodiment of this application, the sealing ring may use one or more of high-temperature-resistant and corrosion-resistant rubber, graphite, or asbestos medium materials.

In the foregoing embodiment, the heat dissipation panel group 35 includes at least one group of heat dissipation fins 3530, and in the first direction X, each group of heat dissipation fins 3530 is fastened to a side that is of the cover plate 353 and that faces the mainboard 351. Each group of heat dissipation fins 3530 includes a plurality of heat dissipation fins 3530, and a length of the heat dissipation fin 3530 is less than or equal to a height of the ring-shaped plate frame 352 in the first direction X, thereby reducing difficulty in assembling the heat dissipation fins 3530 of the cover plate and the ring-shaped plate frame 352, and difficulty in processing the heat dissipation fin 3530. In this embodiment of this application, an outer surface area of the cover plate 353 can be effectively increased by using the heat dissipation fin 3530, thereby improving heat exchange efficiency between the cover plate 353 and the refrigerant. In this embodiment of this application, the heat dissipation fin 3530 includes a pin fin.

In this embodiment of this application, when there is one cover plate 353 and one ring-shaped plate frame 352, in the first direction X, a plurality of groups of heat dissipation fins 3530 are mounted, through fastening, on the side that is of the cover plate 353 and that faces the mainboard 351, and each group of heat dissipation fins 3530 forms a heat dissipation region. When there are a plurality of cover plates 353 and a plurality of ring-shaped plate frames 352, when each ring-shaped plate frame 352 is used to fasten a cover plate 353 in the first direction X, in the first direction X, a group of heat dissipation fins 3530 is mounted, through fastening, on a side that is of each cover plate 353 and that faces the mainboard 351. A group of heat dissipation fins 3530 and a ring-shaped plate frame 352 form a heat dissipation region. In this case, the cavity 350 and the coolant flow channel 30001 are formed on two sides of the mainboard 351 in the first direction X, to implement heat exchange circulation of the heat exchange medium inside the mainboard 351. In addition, the coolant flow channel 30001 is jointly formed by the first sub-housing 3000 and the heat dissipation panel group 35. The cavity 350 is jointly formed by the mainboard 351, the ring-shaped plate frame 352, and the cover plate 353. Therefore, this design can effectively compress sizes of the heat dissipation panel group 35 and the first sub-housing 3000 in a height direction after the heat dissipation panel group 35 is mounted in the first sub-housing 3000, thereby improving structure compactness of the motor control unit.

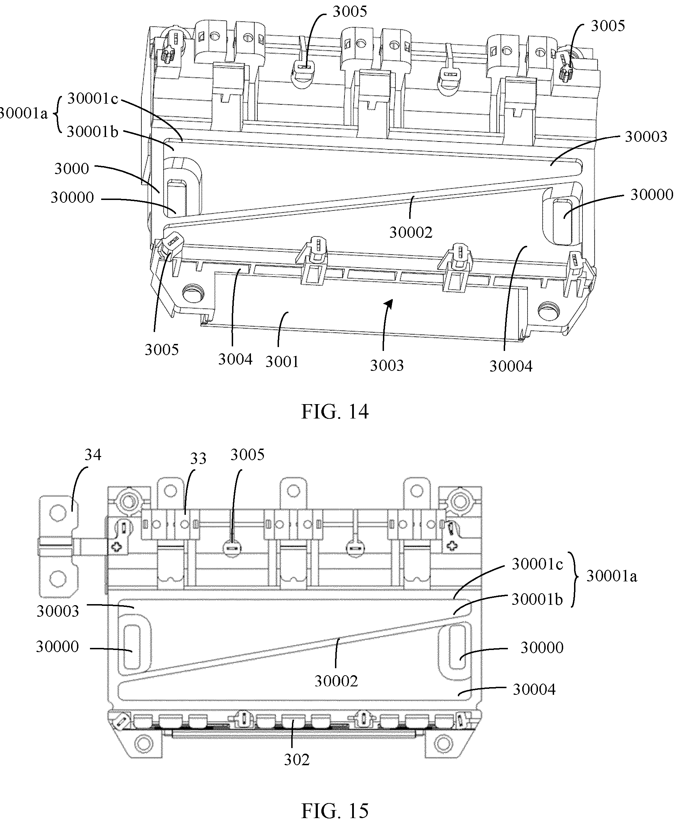

FIG. 14 is a diagram of a structure of the capacitor housing of the motor control unit according to an embodiment of this application. FIG. 15 is a diagram of a structure of the capacitor module and the filter module of the motor control unit according to an embodiment of this application. Refer to FIG. 4, FIG. 6, FIG. 14, and FIG. 15. In an embodiment, in the first direction X, the side that is of the first sub-housing 3000 and that faces the heat dissipation panel group 35 includes a third groove 30001a. In the first direction X, the side that is of the first sub-housing 3000 and that faces the heat dissipation panel group 35 includes the third groove 30001a may be understood as that a side that is of the first sub-housing 3000 and that faces the mainboard 351 includes the third groove 30001a. A gap between the third groove 30001a and the heat dissipation panel group 35 is used to form the coolant flow channel 30001. The refrigerant in the coolant flow channel 30001 can exchange heat with the capacitor core package only via the first sub-housing 3000, to improve heat exchange efficiency of the capacitor core package. The two flow channel openings 30000 penetrate a groove bottom of the third groove 30001a in the first direction X, to ensure supply of the refrigerant. After entering the third groove 30001a through one flow channel opening 30000, the refrigerant communicates with the cavity 350 through the liquid inlet through hole 351a in the at least one group of through holes, to provide the refrigerant for the cavity 350. The refrigerant in the cavity 350 is configured to exchange heat for the power module 310, flows back to the third groove 30001a through the liquid outlet through hole 351b of the at least one group of through holes, and then flows out through the other flow channel opening 30000, to continuously exchange heat for the capacitor core package and the power module 310.

In an embodiment, the first sub-housing 3000 includes a housing separator 30002, and in the first direction X, the housing separator 30002 is located on the side of the first sub-housing 3000 and that faces the heat dissipation panel group 35. The third groove 30001a includes a groove bottom 30001b and a groove wall 30001c, and the housing separator 30002 is fixedly connected to the groove bottom 30001b and the groove wall 30001c. The housing separator 30002 separates the third groove 30001a into two third sub-grooves, and one third sub-groove communicates with one flow channel opening 30000. In the first direction X, a height of the housing separator 30002 is less than or equal to a depth of the third groove 30001a, a length direction of the housing separator 30002 inclines relative to a length direction of the third groove 30001a, a length of the third groove 30001a is less than a length of the housing separator 30002, and projection of the two third sub-grooves 30001a does not overlap in the first direction X. In this embodiment, the housing separator 30002 and the first sub-housing 3000 are of an integrally formed structure, to simplify an assembly process and better isolate the two third sub-grooves. In addition, the height of the housing separator 30002 in the first direction X is less than or equal to the depth of the third groove 30001a, to facilitate assembly of the heat dissipation panel group 35 and the first sub-housing 3000. When the height of the housing separator 30002 in the first direction X is less than the depth of the third groove 30001a, a gap is filled by using glue, to ensure isolation between the two third sub-grooves.

In an embodiment, a liquid inlet flow channel 30004 and a liquid outlet flow channel 30003 may be formed between the two third sub-grooves and the heat dissipation panel group. It may be understood as that the coolant flow channel 30001 includes the liquid inlet flow channel 30004 and a liquid outlet flow channel 30003. In the second direction Y, a width of the liquid inlet flow channel 30004 gradually decreases, and a width of the liquid outlet flow channel 30003 gradually increases. The liquid inlet flow channel 30004 is designed as a structure with a gradually changing width. After the refrigerant flows into the liquid inlet flow channel from the flow channel opening 30000, as the width of the liquid inlet flow channel 30004 becomes narrower, a flow rate of the refrigerant becomes faster. This helps to maintain balance of flow volumes at sections that are in the liquid inlet flow channel 30004 and that are perpendicular to a length direction of the coolant flow channel 30001, so that heat exchange media flowing into the cavity from liquid inlet through holes 351a may also be approximately equal, and heat dissipation uniformity for the power module 310 can be improved.

Refer to FIG. 4, FIG. 6, FIG. 13, FIG. 14, and FIG. 15. In an embodiment, when the mainboard 351 is assembled with the first sub-housing 3000, in the first direction X, a side that is of the mainboard 351 and that faces the first sub-housing 3000 is enclosed with the third groove 30001a to form the coolant flow channel 30001. To increase a volume of the coolant flow channel 30001, the side that is of the mainboard 351 and that faces the first sub-housing 3000 includes a plurality of second grooves 351c, and the plurality of second grooves 351c are spaced in the second direction Y In this manner, the plurality of second grooves 351c are disposed, so that the volume of the coolant flow channel 30001 can be improved, a capacity of the refrigerant can be increased, and strength of the mainboard 351 can be ensured. That each group of through holes penetrates a groove bottom of a second groove 351c in the first direction X may be understood as that each group of through holes penetrates the mainboard 351 in the first direction X, and the plurality of second grooves 351c communicate with the cavity 350 through a plurality of through holes. In addition, in the first direction X, the side that is of the mainboard 351 and that faces the first sub-housing 3000 includes a plurality of groove separators 354, and each groove separator 354 is configured to separate one second groove 351c into two second sub-grooves 351d. Projection of the housing separator 30002 covers the plurality of groove separators 354 in the first direction X, and the plurality of second grooves 351c and the third groove 30001a are enclosed to form the coolant flow channel 30001. In this embodiment, the groove separator 354 and the second groove 351c are produced through integral forming. In the first direction X, projection of the plurality of second sub-grooves 351d coincides with the two third sub-grooves respectively. One of the two third sub-grooves and the plurality of second sub-grooves 351d form the liquid inlet flow channel, the other of the two third sub-grooves and the plurality of second sub-grooves 351d form the liquid outlet flow channel.

In an embodiment, projection of each second groove 351c covers the liquid inlet through hole 351a and the liquid outlet through hole 351b in a group of through holes in the first direction X. The refrigerant flows to a side of the plurality of ring-shaped plate frames 352 and the cover plate 353 through the liquid inlet through hole 351a, and the refrigerant in the plurality of ring-shaped plate frames 352 and the cover plate 353 flows back through the liquid outlet through hole 351b.

Refer to FIG. 4, FIG. 6, FIG. 14, and FIG. 15. In an embodiment, the first sub-housing 3000 includes a plurality of lightening holes 3004, and the plurality of lightening holes 3004 are spaced in the second direction Y The lightening hole 3004 can reduce a weight of the first sub-housing 3000, so that a weight of the motor control unit is reduced. The plurality of lightening holes 3004 are located on a side surface of the first sub-housing 3000. The side surface of the first sub-housing 3000 may be understood as a side wall of the third groove 30001a. A countersunk hole is disposed on a side that is of the side wall of the third groove 30001a and that is away from the flow channel opening 30000, and the countersunk hole is the lightening hole 3004.

In an embodiment, the capacitor module includes a plurality of groups of direct current output copper bars 302, one ends of the plurality of groups of direct current output copper bars 302 are electrically connected to the capacitor core package 301, and the other ends of the plurality of groups of direct current output copper bars 302 are electrically connected to the power module 310, to ensure that a direct current output by the capacitor core package 301 can be output to the power module 310. The other ends of the plurality of groups of direct current output copper bars 302 are spaced in the second direction Y, and projection of the plurality of groups of direct current output copper bars 302 in the third direction Z covers the plurality of lightening holes 3004. The lightening hole 3004 is disposed, so that a distance between the refrigerant in the third groove 30001a and the direct current output copper bar 302 is reduced, and the refrigerant in the third groove 30001a can also cool the plurality of groups of direct current output copper bars 302.

In an embodiment, in the first direction X, a plurality of Hall magnetic core components 33 are arranged on the side that is of the first sub-housing 3000 and that faces the heat dissipation panel group 35, and are sequentially spaced in the second direction Y The plurality of Hall magnetic core components 33 and the plurality of groups of direct current output copper bars 302 are arranged on two sides of the power module 310 or the coolant flow channel respectively. It may be understood as that the plurality of Hall magnetic core components 33 and the plurality of groups of direct current output copper bars 302 are symmetrically arranged. In this embodiment, the plurality of Hall magnetic core components 33 and the plurality of groups of direct current output copper bars 302 are arranged on the two sides of the power module 310 or the coolant flow channel respectively, so that space utilization of the side that is of the first sub-housing 3000 and that faces the heat dissipation panel group 35 can be improved, thereby improving compactness of the motor control unit.

The Hall magnetic core component 33 includes a Hall magnetic core 330 and a copper bar connecting piece 331. The Hall magnetic core 330 includes a magnetic core through hole, and an axis of the magnetic core through hole is parallel to the third direction Z. Each magnetic core through hole is configured to penetrate a copper bar connecting piece 331, and one end of the copper bar connecting piece 331 is configured to electrically connect to a power module 310, so that an alternating current of the power module 310 is output. When the copper bar connecting piece 331 penetrates the magnetic core through hole, there is no electrical connection between the copper bar connecting piece 331 and the Hall magnetic core 330. It may be understood as that, there is a gap between the copper bar connecting piece 331 and an inner wall of the magnetic core through hole in the second direction Y and the third direction Z, to ensure stability of the alternating current output via the copper bar connecting piece 331.

The Hall magnetic core 330 includes an opening. In the third direction Z, the opening is located on a side that is of the Hall magnetic core 330 and that is away from the first sub-housing 3000, and the opening is in communication with the magnetic core through hole. The opening is used to accommodate a detection component. The detection component is configured to detect a current flowing through the copper bar connecting piece 331 or a voltage of the copper bar connecting piece 331.

The capacitor housing 300 includes two rows of support pillars 3005. The two rows of support pillars 3005 and the plurality of Hall magnetic core components 33 are located on a same side of the first sub-housing 3000. The two rows of support pillars 3005 are arranged opposite to each other on the two sides of the power module 310 or the coolant flow channel in the second direction Y The two rows of support pillars 3005 are configured to fasten the circuit board 32. The capacitor housing 300 integrates the two rows of support pillars 3005, so that a structure layout of the motor control unit is compact and highly integrated. This facilitates implementation of a miniaturization design of the motor control unit, and reduces difficulty in and costs of disassembling internal components of the motor control unit.

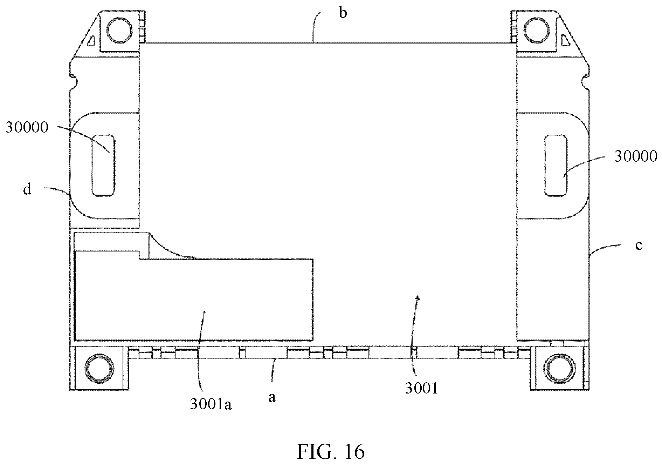

FIG. 16 is a bottom view of the capacitor module of the motor control unit according to an embodiment of this application. Refer to FIG. 5, FIG. 14, FIG. 15, and FIG. 16. In an embodiment, in the first direction X, a side that is of the second sub-housing 3001 and that is away from the first sub-housing 3000 includes a fourth groove 3001a, and the fourth groove 3001a is used to accommodate the filter module 34. In this embodiment, the filter 340 included in the filter module 34 is mounted in the fourth groove 3001a. One end of the direct current connecting piece 341 is electrically connected to the filter 340, and the other end of the direct current connecting piece 341 extends outside the capacitor housing 300. Projection of the direct current connecting piece 341 in the first direction X does not overlap the capacitor housing 300 and the plurality of groups of direct current output copper bars 302. The other end of the direct current connecting piece 341 and the plurality of Hall magnetic core components 33 are spaced in the second direction Y

In the first direction X, a side surface that is of the second sub-housing 3001 and that is away from the first sub-housing 3000 includes a first side a, a second side b, a third side c, and a fourth side d. The first side a is disposed opposite to the second side b, and the third side c is disposed opposite to the fourth side d. A part of the copper bar connecting piece 331 protrudes from the capacitor housing. The two flow channel openings 30000 are located between the first side a and the second side b. One of the two flow channel openings 30000 is close to the fourth side d, and the other of the two flow channel openings 30000 is close to the third side c. The distance between the two flow channel openings 30000 is large, so that mounting of the capacitor core package can be ensured, and when the refrigerant is provided for the two flow channel openings 30000, another component does not need to be avoided. In some embodiments, the fourth groove 3001a is disposed between the flow channel opening 30000 close to the fourth side d and the copper bar connecting piece 331. It may be understood as that, after the filter 340 is mounted in the capacitor housing, the filter 340 is located between the flow channel opening 30000 close to the fourth side d and the copper bar connecting piece 331. One end of the direct current connecting piece 341 is connected to the filter 340, the other end of the direct current connecting piece 341 is located on the fourth side d, and the other end of the direct current connecting piece 341 extends towards the first sub-housing 3000, so that interference of the direct current connecting piece 341 to the copper bar connecting piece 331 is small. The direct current output copper bar 302 and the copper bar connecting piece 331 are arranged opposite to each other, and the direct current connecting piece 341 is far away from the direct current output copper bar 302. Therefore, interference of the direct current connecting piece 341 to the direct current output copper bar 302 is smaller than that of the direct current connecting piece 341 to the copper bar connecting piece 331.

In an embodiment, the fourth groove 3001a is disposed between the flow channel opening 30000 close to the third side c and the copper bar connecting piece 331. It may be understood as that, after the filter 340 is mounted in the capacitor housing, the filter 340 is located between the flow channel opening 30000 close to the third side c and the copper bar connecting piece 331. One end of the direct current connecting piece 341 is connected to the filter 340, the other end of the direct current connecting piece 341 is located on the third side c, and the other end of the direct current connecting piece 341 extends towards the first sub-housing 3000, so that the interference of the direct current connecting piece 341 to the copper bar connecting piece 331 is small. The direct current output copper bar 302 and the copper bar connecting piece 331 are arranged opposite to each other, and the direct current connecting piece 341 is far away from the direct current output copper bar 302. Therefore, the interference of the direct current connecting piece 341 to the direct current output copper bar 302 is smaller than that of the direct current connecting piece 341 to the copper bar connecting piece 331.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. A motor control unit, wherein the motor control unit comprises:
a three-phase bridge arm, wherein the three-phase bridge arm comprises a plurality of power modules;
a capacitor module, wherein the capacitor module comprises a capacitor housing and a capacitor core package, the capacitor housing comprises a first sub-housing and a second sub-housing, the first sub-housing and the second sub-housing are spaced in a first direction, a gap between the first sub-housing and the second sub-housing forms an accommodating cavity in the first direction, and the accommodating cavity is used to accommodate the capacitor core package; and
a heat dissipation panel group, wherein the heat dissipation panel group is configured to dissipate heat for the plurality of power modules, the heat dissipation panel group is configured to be fixedly connected to a side that is of the first sub-housing and that is away from the capacitor core package in the first direction, and a gap between the heat dissipation panel group and the first sub-housing in the first direction is used to form a coolant flow channel, wherein
the first sub-housing comprises two flow channel openings, and the two flow channel openings are used to communicate with the coolant flow channel.

2. The motor control unit according to claim 1, wherein a side that is of the heat dissipation panel group and that is away from the first sub-housing is used to fasten the plurality of power modules, and the plurality of power modules are spaced in a second direction.

3. The motor control unit according to claim 1 or 2, wherein the heat dissipation panel group comprises a cavity and at least one group of through holes, each group of through holes comprises a liquid inlet through hole and a liquid outlet through hole, each liquid inlet through hole is configured to communicate the coolant flow channel with the cavity, and each liquid outlet through hole is configured to communicate the coolant flow channel with the cavity.

4. The motor control unit according to claim 3, wherein the heat dissipation panel group comprises a mainboard and at least one cover plate, the mainboard is configured to be fixedly connected to the side that is of the first sub-housing and that is away from the capacitor core package in the first direction, the at least one cover plate is configured to be fixedly connected to a side that is of the mainboard and that is away from the first sub-housing in the first direction, a gap between the mainboard and the at least one cover plate is used to form the cavity, and a side that is of the at least one cover plate and that is away from the mainboard in the first direction is used to fasten the plurality of power modules.

5. The motor control unit according to claim 4, wherein the heat dissipation panel group comprises a plurality of cavities, a gap between each cover plate and the mainboard is used to form one cavity, the plurality of cavities are spaced in the second direction, and each group of through holes is configured to communicate the coolant flow channel with the one cavity.

6. The motor control unit according to claim 5, wherein a side that is of the mainboard and that is away from the first sub-housing comprises a plurality of first grooves, and each first groove is configured to be fixedly connected to the cover plate to form the cavity, wherein
each group of through holes penetrates a groove bottom of the first groove in the first direction, and the plurality of first grooves are sequentially spaced in the second direction.

7. The motor control unit according to claim 6, wherein the heat dissipation panel group comprises a plurality of ring-shaped plate frames, each ring-shaped plate frame is configured to fixedly connect the cover plate to the first groove, and a material of the ring-shaped plate frame is different from a material of either the cover plate or the groove.

8. The motor control unit according to any one of claims 3 to 7, wherein a side that is of the mainboard and that faces the first sub-housing comprises a plurality of second grooves, wherein
each group of through holes penetrates a groove bottom of the second groove in the first direction, and the plurality of second grooves are spaced in the second direction.

9. The motor control unit according to claim 8, wherein the side that is of the mainboard and that faces the first sub-housing comprises a plurality of groove separators, each groove separator is configured to separate one second groove into two second sub-grooves, and the two second sub-grooves are configured to communicate with a group of through holes separately.

10. The motor control unit according to claim 1, wherein a side that is of the first sub-housing and that faces the heat dissipation panel group comprises a third groove, and a gap between the third groove and the heat dissipation panel group in the first direction is used to form the coolant flow channel.

11. The motor control unit according to claim 10, wherein the side that is of the first sub-housing and that faces the heat dissipation panel group comprises a housing separator, the housing separator is configured to separate the third groove into two third sub-grooves, one third sub-groove is configured to communicate with a liquid inlet through hole in at least one group of through holes, and the other third sub-groove is configured to communicate with a liquid outlet through hole in the at least one group of through holes.

12. The motor control unit according to any one of claims 1 to 11, wherein the accommodating cavity comprises an opening, an orientation of the opening is in a third direction, and the capacitor core package is embedded into the accommodating cavity along the opening.

13. A powertrain, wherein the powertrain comprises a motor and the motor control unit according to any one of claims 1 to 12, and the motor control unit is configured to drive the motor.

14. A vehicle, wherein the vehicle comprises wheels and the powertrain according to claim 13, and the powertrain is configured to drive the wheels.
